# EUROPÄISCHE PATENTSCHRIFT

(11) **EP 0 849 847 B1**
(45) Veröffentlichungstag und Bekanntmachung des Hinweises auf die Patenterteilung: **19.09.2001**
(21) Anmeldenummer: 97122326.8
(22) Anmeldetag: 17.12.1997
(51) Int. Cl.: H01S 5/34, H01S 5/026, G02F 1/017

(54) **Optoelektronisches Bauelement mit MQW-Stukturen**
Optoelectronic element with MQW structure
Elément optoélectronique avec une structure MQW

(30) Priorität: 17.12.1996 DE 19652529
(43) Veröffentlichungstag der Anmeldung: 24.06.1998
(73) Patentinhaber: Infineon Technologies AG, 81669 München (DE)
(72) Erfinder: Stegmüller, Bernhard, Dr.-Ing., 86163 Augsburg (DE)
(74) Vertreter: Fischer, Volker, Dipl.-Ing.

(56) Entgegenhaltungen:
- EP-A- 0 578 557
- EP-A- 0 627 798
- SATO K ET AL: "ACTIVELY MODE-LOCKED STRAINED-INGAASP MULTIQUANTUM-WELL LASERS INTEGRATED WITH ELECTROABSORPTION MODULATORS AND DISTRIBUTED BRAGG REFLECTORS" IEEE JOURNAL OF SELECTED TOPICS IN QUANTUM ELECTRONICS, Bd. 2, Nr. 3, 1. September 1996, Seiten 557-564, XP000689817
- KOTAKA I ET AL: "HIGH-SPEED (20 GB/S), LOW-DRIVE VOLTAGE (2 VP-P) STRAINED INGAASP MQW MODULATOR/DFB LASER LIGHT SOURCE" ELECTRONICS & COMMUNICATIONS IN JAPAN, PART II - ELECTRONICS, Bd. 78, Nr. 1, 1. Januar 1995, Seiten 1-8, XP000523235
- PATENT ABSTRACTS OF JAPAN vol. 014, no. 541 (E-1007), 29. November 1990 -& JP 02 229485 A (FUJITSU LTD), 12. September 1990
- STEINMANN ET AL.: "Improved monolithic laser/modulator behaviours by a modified identical active layer structure" CONFERENCE PROCEEDINGS, 10TH ANNUAL MEETING, IEEE LASERS AND ELECTRO-OPTICS SOCIETY, 10 -1 3 NOV. 1997, Bd. 1, Seiten 148-149, XP002101705 San Francisco, CA, US

## Beschreibung

In Bauelementen, in denen zwei oder mehrere optoelektronische Komponenten monolithisch integriert sind, wie z. B. bei einer Laser-Modulator-Kombination, sind oftmals unterschiedliche MQW-Strukturen mit unterschiedlichen Eigenschaften erforderlich. Derartige MQW-Strukturen (Multiple Quantum Well), nachfolgend auch als mehrfache Potentialtopfstrukturen bezeichnet, sind durch eine alternierende Schichtfolge gegeben, in der jeweils eine als Potentialtopf (Well) fungierende Schicht zwischen zwei Barriereschichten angeordnet ist. Üblicherweise sind die Potentialtopfschichten und die Barriereschichten untereinander jeweils gleichartig ausgebildet, d. h. die Schichten besitzen jeweils dieselbe Materialzusammensetzung und Dicke. Bei der Integration mehrerer optoelektronischer Komponenten unterschiedlicher Funktion auf demselben Chip ist es oftmals erforderlich, mehrere wesentlich voneinander verschiedene MQW-Strukturen monolithisch zu integrieren.

Eine Möglichkeit der gemeinsamen Integration z. B. eines Modulators mit einer Laserdiode ist in der Veröffentlichung von K. Morito e.a.: "A Low-Wavelength-Chirp, Low-Drive-Voltage MQW Modulator Integrated DFB Laser for 10 Gb/s Transmission" in Optoelectronics 10, 89 bis 96 (1995) beschrieben. Die dort angegebene sogenannte Butt-joint-Struktur wird hergestellt, indem die MQW-Schichtfolgen für den Laser und den Modulator getrennt in mehrfachen Epitaxieprozessen aufgewachsen werden. In dieser Veröffentlichung ist auch ein Vergleich mit einer mit Hilfe von selektiver Epitaxie hergestellten Schichtstruktur gezogen, wie sie z. B. bei der Herstellung der Laser-Modulator-Kombination verwendet wird, die in der Veröffentlichung von H. Yamazaki e.a.: "Low Drive Voltage (1.5 V_{p.p.}) and High Power DFB-LD/Modulator Integrated Light Sources by Band-gap Energy Controlled Selective MOVPE" in Proc. of the 21st Eur. Conf. on Opt. Comm. (ECOC'95, Brussels), Seite 897 bis 900 (1995) beschrieben ist. Diese mehrfachen Epitaxieprozesse oder selektiven Epitaxieprozesse sind zeitaufwendig und stellen mögliche Fehlerquellen dar. In der Veröffentlichung von A. Ramdane e.a.: "Integrated MQW Laser-Modulator with 36 Ghz Bandwidth and Negative Chirp" in Proc. of the 21st Eur. Conf. on Opt. Comm., Seiten 893 bis 896 (1995) wurde eine Laser-Modulator-Kombination mit nur einer gemeinsamen MQW-Struktur vorgeschlagen. Deren Herstellung kann daher in einem Epitaxieprozeß erfolgen. Die MQW-Struktur kann aber nicht für beide integrierte Komponenten gleichzeitig optimiert werden.

In den Veröffentlichungen von K. Sato, I. Kotaka et al.: "Actively Mode-Locked Strained-InGaAsP Multiquantum-Well Lasers Integrated with Electroabsorption Modulators and Distributed Bragg Reflectors" in Quantum Electronics 2, 557-564 (1996) und "High-Speed (20 Gb/s), Low-Drive Voltage (2 Vₚ₋ₚ) Strained InGaAsP MQW Modulator/DFB Laser Light Source" in Electronics and Communications in Japan, Part 2, 78, 1 - 8 (1995) ist eine Modulator-Laserdiode-Kombination beschrieben, bei der eine für den Modulator vorgesehene MQW-Schichtfolge im Materialsystem von InP auch im Bereich der Laserdiode vorhanden ist. Darauf befindet sich im Bereich der Laserdiode eine Zwischenschicht aus InP und darauf eine MQW-Schichtfolge für die Laserdiode, die auf den Laser begrenzt ist.

Aufgabe der vorliegenden Erfindung ist es, eine monolithische Integration einer Laserdiode mit einem Modulator anzugeben, bei der die Laserdiode und der Modulator unterschiedliche MQW-Strukturen aufweisen und die möglichst einfach herstellbar ist.

Diese Aufgabe wird mit dem Bauelement mit den Merkmalen des Anspruches 1 gelöst. Weitere Ausgestaltungen ergeben sich aus den abhängigen Ansprüchen.

In dem erfindungsgemäßen Bauelement sind voneinander unterscheidbare MQW-Strukturen so integriert, daß sie in einem Epitaxieprozeß hergestellt werden können und daß sie gleichzeitig eine Optimierung für zwei oder mehrere integrierte Komponenten ermöglichen. Die MQW-Strukturen sind als Schichtfolgen in einer gemeinsamen, und daher in einem einzigen Epitaxieprozeß herstellbaren, Folge von Schichten angeordnet. Die MQW-Schichtfolgen, die jeweils für eine der Komponenten optimiert sind, sind vorzugsweise vertikal zur Ebene der Schichten gegeneinander versetzt angeordnet. Eine dieser Schichtfolgen kann aber integraler Bestandteil der für die andere Komponente vorgesehenen MQW-Schichtfolge sein. Im Fall einer Laserdiode-Modulator-Kombination wird vorzugsweise die für die aktive Schicht der Laserdiode vorgesehene MQW-Struktur auch im Bereich des Modulators vorgesehen. Die speziell für den Modulator vorgesehene Schichtfolge ist vorzugsweise teilweise über und teilweise unter dieser MQW-Struktur der Laserdiode angeordnet. Die speziell für die MQW-Struktur des Modulators vorgesehenen Schichten können z. B. nur im Bereich des Modulators aufgewachsen oder im Bereich der Laserdiode nachträglich durch Ätzen entfernt sein. Die für die getrennten Funktionen der integrierten Komponenten vorgesehenen verschiedenen MQW-Schichtfolgen können dadurch voneinander unterschieden werden, daß die darin enthaltenen Schichten eine andere Materialzusammensetzung aufweisen und/oder die Dikke und Anzahl der Schichten unterschiedlich ist.

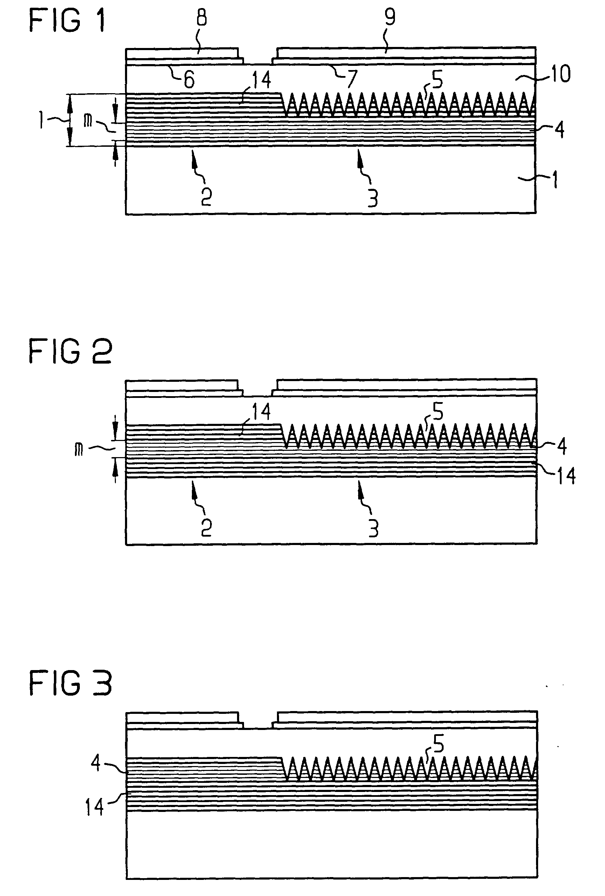

Es folgt eine genauere Beschreibung des erfindungsgemäßen Bauelementes anhand der Figuren 1 bis 5. Die Figuren zeigen jeweils eine Ausgestaltung einer erfindungsgemäßen Laser-Modulator-Kombination im Längsschnitt.

In Figur 1 ist eine Kombination eines Modulators 2 mit einer Laserdiode 3 auf demselben Substrat 1 dargestellt. Eine mehrfache Potentialtopfstruktur (Multiple Quantum Well, MQW) 4 ist im Bereich des Modulators und der Laserdiode vorhanden. Diese MQW-Struktur, die für die aktive Schicht der Laserdiode vorgesehen ist, hat eine Dicke m, die geringer ist als die gesamte Dicke 1 aller für MQW-Strukturen aufgewachsenen Schichten. Die für den Modulator vorgesehene Schichtfolge 14 bildet die für den Modulator 2 optimierte MQW-Struktur. Im Bereich der Laserdiode 3 ist in dieser Schichtfolge oberhalb der für den Laser vorgesehenen Schichtfolge 4 ein Gitter 5 durch Ätzen hergestellt. Dieses Gitter ist hier als DFB-Gitter (Distributed Feedback) auf der gesamten Länge des Lasers vorhanden. Das Gitter braucht nicht auf der gesamten Länge des Lasers vorhanden zu sein, sondern kann auf einen oder mehrere Teilabschnitte des Lasers begrenzt sein. Ebenso kann ein DBR-Gitter als Ersatz für die hier fehlenden Spiegelendflächen vorgesehen sein. Kontaktschichten 6, 7 aus hochdotiertem Halbleitermaterial mit dafür aufgebrachten Kontakten 8, 9 aus Metall dienen einer getrennten Strominjektion in den Bereich des Modulators und des Lasers. Ein gemeinsamer Gegenkontakt kann z. B. auf der Oberseite vor oder hinter der Zeichenebene oder auf der Unterseite des dann elektrisch leitend dotierten Substrates 1 aufgebracht sein. Die Dicke m der MQW-Schichtfolge 4 ist geringer als die Dicke 1 der gesamten aufgewachsenen Folge von Schichten, die für MQW-Strukturen vorgesehen sind. Die für den Modulator optimierte Schichtfolge 14 ist hier dicker eingezeichnet als die für die Laserdiode optimierte Schichtfolge 4. Die Dicken der Schichten können aber bei beiden Komponenten gleich sein, und der Unterschied zwischen den MQW-Strukturen kann durch die unterschiedliche Materialzusammensetzung gegeben sein.

Figur 2 und Figur 3 zeigen im Prinzip den gleichen Aufbau wie die Laser-Modulator-Kombination der Figur 1. Im Gegensatz zu dem Ausführungsbeispiel der Figur 1 ist aber die für die Laserdiode vorgesehene Schichtfolge 4 bei der Anordnung der Figur 2 etwa in der Mitte der für den Modulator vorgesehenen Schichtfolge 14 angeordnet und bei dem Ausführungsbeispiel der Figur 3 im oberen Bereich, d. h. sich überschneidend mit dem DFB-Gitter 5. Auch bei den Ausführungen entsprechend Figuren 2 und 3 braucht das Gitter nicht auf der gesamten Länge des Lasers vorhanden zu sein.

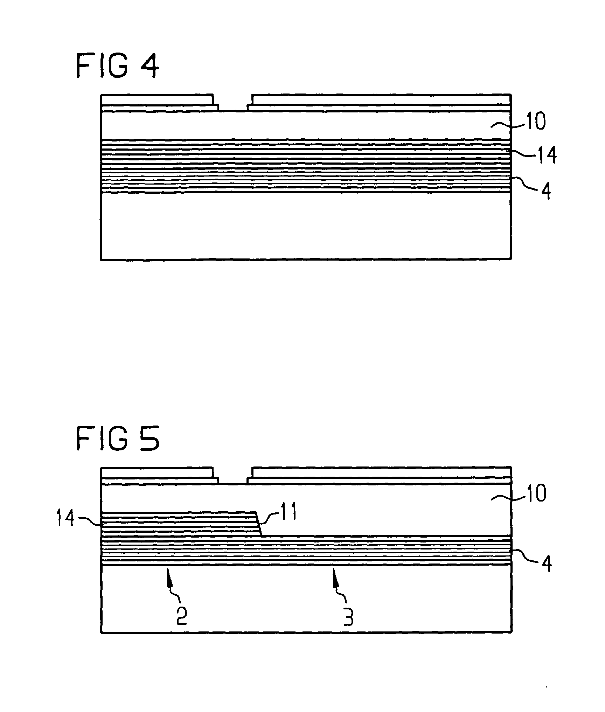

Bei der Ausführungsform der Figur 4 ist die gesamte Folge von Schichten gleichmäßig im Bereich des Modulators und der Laserdiode vorhanden. Bei einer Anordnung der für den Laser vorgesehenen Schichtfolge 4 wie bei der Ausführung gemäß Figur 4 kann z. B. der obere Anteil der Schichtfolge 14 für den Modulator im Bereich der Laserdiode entfernt sein, wie das in Figur 5 dargestellt ist. Es ergibt sich dann eine steile Grenzfläche 11 am Ende der für den Modulator vorgesehenen Schichtfolge 14 zur Laserdiode hin.

Bei allen dargestellten Ausführungsbeispielen ist auf die Oberseite der Folge von MQW-Schichten eine Deckschicht oder Mantelschicht 10 aufgebracht, mit der insbesondere auch das Gitter aufgefüllt wird. Es können über und unter den MQW-Schichten weitere Mantelschichten vorgesehen sein, die insbesondere für optisches und elektrisches Confinement benötigt werden können. Eine Alternative zu der Ausführungsform der Figur 5 ist dadurch gegeben, daß z. B. im Bereich des Modulators ein Anteil des Substrates 1 oder einer darauf aufgebrachten unteren Mantelschicht entfernt wird. Die Epitaxie der MQW-Schichten erfolgt dann zunächst nur innerhalb des ausgeätzten Bereiches. Der restliche Anteil der Halbleiteroberfläche wird vorzugsweise mit einer Maske abgedeckt. Nachdem so viele Schichten aufgewachsen sind, daß sich eine ebene Oberfläche ergibt, werden die nachfolgenden Schichten im Bereich beider Komponenten gleich aufgewachsen. Auf diese Weise ergibt sich eine Grenzfläche 11 wie in Figur 5 nicht über, sondern unter der für die Laserdiode vorgesehenen Schichtfolge 4.

Bei dem erfindungsgemäßen Bauelement wird vorzugsweise die Folge von Schichten, die für die MQW-Strukturen vorgesehen sind, ohne Unterbrechung in einem Epitaxieprozeß aufgewachsen, und zwar so, daß keine Schichten, die nicht zu den MQW-Strukturen gehören, in die Folge von Schichten eingefügt werden. In der für die MQW-Strukturen vorgesehenen Schichtfolge folgen daher unmittelbar aufeinander nur Schichten, die entweder für die MQW-Struktur der einen Komponente oder für die MQW-Struktur der anderen Komponente vorgesehen sind oder die Teil beider MQW-Strukturen bilden. Die gesamte Folge von Schichten kann vor dem Aufbringen der oberen Mantelschicht 10 lateral streifenförmig geätzt werden. Die obere Mantelschicht 10 bedeckt daher auch die seitlichen Ränder dieses Streifens, die vor bzw. hinter der Zeichenebene zu denken sind.

Auch bei dem Ausführungsbeispiel der Figur 4, bei dem alle Schichten beiden Komponenten gemeinsam sind, ist eine Optimierung der jeweiligen MQW-Strukturen auf die Belange der jeweiligen Komponente möglich. Vorzugsweise ist die eine Schichtfolge, die die MQW-Struktur des einen Bauelementes bildet, innerhalb der für die MQW-Struktur des anderen Bauelementes vorgesehenen Schichtfolge 14 angeordnet. Die beiden MQW-Strukturen können aber auch voneinander getrennt vertikal bezüglich der Schichtebenen gegeneinander versetzt angeordnet sein. Auch in diesem Fall wird man die beiden Schichtfolgen, die die MQW-Strukturen der Komponenten bilden, unmittelbar aneinander anschließend aufwachsen. Die in den Figuren dargestellte Ausführung, bei der die Schichtfolge 4 der Laserdiode in die umfassende Schichtfolge 14 für den Modulator eingefügt ist, hat den Vorteil, daß die für die MQW-Struktur des Modulators vorgesehenen Schichten im Bereich der Laserdiode zur Wellenführung genutzt werden können. Das erfindungsgemäße Bauelement kann in jedem Materialsystem hergestellt werden, das für die einzelnen Komponenten verwendbar ist, z. B. InGaAsP oder InGaAlAs. Die Struktur der Bauelemente in lateraler Richtung, d. h. in den Schichtebenen kann entsprechend einer herkömmlichen einzelnen Komponente hergestellt werden. Statt des anhand der Beispiele beschriebenen Bauelementes mit einer integrierten Laserdiode und einem zugehörigen Modulator können zwei oder mehrere Komponenten mit getrennten MQW-Strukturen und praktisch beliebigen Funktionen miteinander integriert werden. Es ist z. B. möglich, eine Laserdiode mit zwei verschiedenen Modulatoren oder zwei voneinander verschiedene Laserdioden oder Photodioden miteinander zu kombinieren. Ein besonderer Vorteil dieses Bauelementes ist die einfache Herstellbarkeit in einem einfachen Epitaxieprozeß. In jeder Schichtebene ist daher nur eine einzige Schicht homogener Zusammensetzung vorhanden.

## Patentansprüche

1. Optoelektronisches Bauelement in Halbleitermaterial mit einer Laserdiode (3) und einem Modulator (2), die jeweils eine Schichtfolge (4, 14) mit einer mehrfachen Potentialtopfstruktur (multiple quantum well) aufweisen,
- bei dem diese Schichtfolgen (4, 14) auf Grund der Zusammensetzungen der Materialien oder der Dicken und Anzahl der darin vorhandenen Schichten voneinander unterscheidbare mehrfache Potentialtopfstrukturen bilden,
- bei dem diese Schichtfolgen Teile einer Folge von übereinander angeordneten homogenen Schichten sind und
- bei dem in jeder Ebene einer Schicht nur eine einzige dieser Schichten vorhanden ist,
**dadurch gekennzeichnet, daß**
- jede Schicht der Laserdiode in dem Modulator vorhanden ist.

2. Bauelement nach Anspruch 1,
bei dem zwischen je zwei Schichten, die einer der Schichtfolgen mit einer mehrfachen Potentialtopfstruktur oder diesen beiden Schichtfolgen zugehören, nur Schichten vorhanden sind, die mindestens einer dieser Schichtfolgen zugehören.

3. Bauelement nach Anspruch 1 oder 2,
bei dem eine der Schichtfolgen mit einer mehrfachen Potentialtopfstruktur zwischen Schichten der anderen Schichtfolge angeordnet ist.

4. Bauelement nach Anspruch 3,
bei dem die Schichtfolge (4) mit einer mehrfachen Potentialtopfstruktur, die für die Laserdiode vorgesehen ist, innerhalb der Schichtfolge (14), die für den Modulator vorgesehen ist, angeordnet ist.

5. Bauelement nach einem der Ansprüche 1 bis 4,
bei dem die Schichtfolge (14) mit einer mehrfachen Potentialtopfstruktur, die für den Modulator vorgesehen ist, Schichten umfaßt, die nur im Bereich des Modulators vorhanden sind.

6. Bauelement nach einem der Ansprüche 1 bis 4,
bei dem die Schichtfolgen (4, 14) mit einer mehrfachen Potentialtopfstruktur nur Schichten umfassen, die sowohl im Bereich der Laserdiode als auch im Bereich des Modulators vorhanden sind.

7. Bauelement nach einem der Ansprüche 1 bis 6,
bei dem im Bereich der Laserdiode in mindestens einer Schichtfolge mit einer mehrfachen Potentialtopfstruktur ein DFB-Gitter oder ein DBR-Gitter ausgebildet ist.

## Claims

1. Optoelectronic component in semiconductor material with a laser diode (3) and a modulator (2), which each have a layer sequence (4, 14) with a multiple potential well structure (multiple quantum well),
- in which the said layer sequences (4, 14) form multiple potential well structures that can be distinguished from one another on account of the compositions of the materials or the thicknesses and number of the layers present therein,
- in which the said layer sequences are parts of a sequence of homogeneous layers arranged one above the other, and
- in which, in each plane of a layer, only a single one of the said layers is present,
**characterized in that**
- each layer of the laser diode is present in the modulator.

2. Component according to Claim 1,
in which, between each two layers which are associated with one of the layer sequences with a multiple potential well structure or both of the said layer sequences, only layers which are associated with at least one of the said layer sequences are present.

3. Component according to Claim 1 or 2,
in which one of the layer sequences with a multiple potential well structure is arranged between layers of the other layer sequence.

4. Component according to Claim 3,
in which the layer sequence (4) with a multiple potential well structure, which is provided for the laser diode, is arranged within the layer sequence (14), which is provided for the modulator.

5. Component according to one of Claims 1 to 4,
in which the layer sequence (14) with a multiple potential well structure, which is provided for the modulator, comprises layers which are present only in the region of the modulator.

6. Component according to one of Claims 1 to 4,
in which the layer sequences (4, 14) with a multiple potential well structure comprise only layers which are present both in the region of the laser diode and in the region of the modulator.

7. Component according to one of Claims 1 to 6,
in which a DFB grating or a DBR grating is formed in the region of the laser diode in at least one layer sequence with a multiple potential well structure.

## Revendications

1. Composant optoélectronique en matériau semi-conducteur comprenant une diode (3) laser et un modulateur (2), qui comporte respectivement une succession (4, 14) de couches ayant une structure à puits de potentiel multiple (multiple quantum well),
- dans lequel cette succession (4, 14) de couches forme, sur la base des compositions des matériaux ou des épaisseurs et du nombre des couches qui y sont présentes, des structures à puits de potentiel multiple qui peuvent être distinguées les unes des autres,
- dans lequel ces suites de couches font partie d'une suite de couches homogènes superposées et
- dans lequel il est présent dans chaque plan d'une couche seulement une seule de ces couches,
**caractérisé en ce que**
- chaque couche de la diode laser est présente dans le modulateur.

2. Composant suivant la revendication 1,
dans lequel il est présent entre respectivement deux couches qui appartiennent à l'une des suites de couches ayant une structure à puits de potentiel multiple ou à ces deux suites de couches, seulement des couches qui appartiennent au moins à l'une de ces suites de couche.

3. Composant suivant la revendication 1 ou 2,
dans lequel l'une des suites de couches ayant une structure à puits de potentiel multiple est interposée entre des couches de l'autre suite de couches.

4. Composant suivant la revendication 3,
dans lequel la suite (4) de couches ayant une structure à puits de potentiel multiple qui est prévue pour la diode laser est disposée au sein de la suite (14) de couches qui est prévue pour le modulateur.

5. Composant suivant l'une des revendications 1 à 4,
dans lequel la suite (14) de couches ayant une structure à puits de potentiel multiple qui est prévue pour le modulateur comprend des couches qui ne sont présentes que dans la région du modulateur.

6. Composant suivant l'une des revendications 1 à 4,
dans lequel les suites (4, 14) de couches ayant une structure à puits de potentiel multiple ne comprennent que des couches qui sont présentes à la fois dans la zone de la diode laser et dans la zone du modulateur.

7. Composant suivant l'une des revendications 1 à 6,
dans lequel il est formé dans la zone de la diode laser dans au moins l'une des suites de couches ayant une structure à puits de potentiel multiple un réseau DFB ou un réseau DBR.
